# EUROPÄISCHE PATENTSCHRIFT

(11) **EP 4 088 314 B1**
(45) Veröffentlichungstag und Bekanntmachung des Hinweises auf die Patenterteilung: **15.05.2024**
(21) Anmeldenummer: 21711756.3
(22) Anmeldetag: 26.02.2021
(51) Int. Cl.: H01L 23/049, H05K 1/11, H01L 23/24, H05K 3/36, H02M 7/00, H05K 1/14, H05K 3/40, H05K 3/46

(54) **HALBLEITERMODUL MIT EINEM GEHÄUSE**
SEMICONDUCTOR MODULE WITH A HOUSING
MODULE SEMI-CONDUCTEUR DOTÉ D'UN BOÎTIER

(30) Priorität: 17.04.2020 EP 20170116
(43) Veröffentlichungstag der Anmeldung: 16.11.2022
(73) Patentinhaber: Siemens Aktiengesellschaft, 80333 München (DE)
(72) Erfinder: NÄHRIG, Matthias, 91334 Hemhofen (DE); SCHMENGER, Jens, 91301 Forchheim (DE)
(74) Vertreter: Siemens Patent Attorneys
(86) Internationale Anmeldenummer: PCT/EP2021/054833
(87) Internationale Veröffentlichungsnummer: WO 2021/209186

(56) Entgegenhaltungen:
- EP-A1- 1 624 531
- EP-A2- 1 032 042
- CN-A- 106 611 758
- US-A1- 2012 320 545
- US-A1- 2018 241 319
- US-B1- 10 581 426

## Beschreibung

Die Erfindung betrifft ein Halbleitermodul mit einem Gehäuse, mindestens einem Halbleiterbauelement, einem ersten Substrat und einem zweiten Substrat.

Ferner betrifft die Erfindung einen Umrichter mit mindestens einem derartigen Halbleitermodul.

Darüber hinaus betrifft die Erfindung ein Verfahren zu Herstellung eines derartigen Halbleitermoduls, wobei das erste Substrat mit dem Pin verbunden wird und daraufhin das zweite Substrat mit demselben Pin verbunden wird.

Halbleitermodule, insbesondere Leistungsmodule, umfassen in der Regel Halbleiterbauelemente, insbesondere Leistungshalbleiter, beispielsweise IGBTs (Insulated-Gate Bipolar Transistoren), welche in einem Gehäuse aufgenommen und mit einem Keramiksubstrat verbunden sind. Das Halbleitermodul umfasst ferner zumindest zwei weitere Substrate, beispielsweise eine Hauptplatine mit einem Interface und eine Treiberplatine, welche mit dem Keramiksubstrat kontaktiert sind. Zur Kontaktierung werden separate Kontakte, Pins genannt, verwendet, die im Gehäuse oder auf dem Keramiksubstrat befestigt sind. Diese Kontakte benötigen Bauraum, wodurch die Größe des Leistungsmoduls beeinflusst wird.

Die Patentschrift DE 10 2017 207 382 B4 beschreibt eine Halbleitervorrichtung aufweisend eine Leistungsvorrichtung, einen Sensor, welcher einen physikalischen Zustand der Leistungsvorrichtung misst, um ein Signal gemäß dem physikalischen Zustand zu übertragen, einen Hauptelektrodenanschluss, durch welchen ein Hauptstrom der Leistungsvorrichtung fließt, einen Sensorsignalanschluss, der mit dem Sensor verbunden ist, um ein Signal von dem Sensor zu empfangen, einen Treiberanschluss, welcher eine Treiberleistung empfängt, um die Leistungsvorrichtung zu treiben und ein Gehäuse mit offener Unterseite, welches die Leistungsvorrichtung, den Sensor, den Hauptelektrodenanschluss, den Sensorsignalanschluss und den Treiberanschluss aufnimmt, wobei der Sensorsignalanschluss und der Treiberanschluss beide einen ersten Anschluss und einen zweiten Anschluss aufweisen, welche von einer inneren Seitenwandoberfläche des Gehäuses entfernt vorgesehen sind, wobei der erste und zweite Anschluss elektrisch miteinander verbunden sind, um eine Doppelstruktur zu bilden. Der erste Anschluss weist eine Länge auf, die ermöglicht, dass ein vorderes Endteil davon von einer oberen Oberfläche des Gehäuses außen vorsteht und das Signal und die Treiberleistung von/nach außen eingibt/ausgibt. Der zweite Anschluss weist eine Länge auf, die nicht zulässt, dass ein vorderes Endteil davon von der oberen Oberfläche des Gehäuses außen vorsteht.

Die Offenlegungsschrift EP 2 086 064 A1 beschreibt einen elektrischen Einpresskontakt, insbesondere einen Einpressstiftkontakt, zur Übertragung von elektrischem Strom und/oder elektrischen Signalen, mit einem Einpressabschnitt und einem Montageabschnitt, die über einen Entlastungsabschnitt miteinander mechanisch gekoppelt sind. Der Entlastungsabschnitt weist einen Ausgleichsbereich und einen Anschlagbereich auf, wobei der Ausgleichsbereich eine gekoppelte Relativbewegung des Einpressabschnitts und des Montageabschnitts zulässt, und der Anschlagbereich eine Aufeinanderzubewegung von Einpressabschnitt und Montageabschnitt blockiert.

Die Offenlegungsschrift US 2018/0241319 A1 beschreibt eine elektronische Vorrichtung aufweisend ein erstes Substrat, ein Verdrahtungssubstrat (zweites Substrat), das über dem ersten Substrat angeordnet ist, und ein Gehäuse, in dem das erste Substrat und das Verdrahtungssubstrat untergebracht sind und das eine erste Seite und eine zweite Seite aufweist.

Die Offenlegungsschrift EP 1 032 042 A2 beschreibt einen Stromrichter umfassend ein Halbleitermodul, das eine Leistungseinheit enthält, die aus einem Leistungshalbleiter und einer Steuereinheit zum Steuern des Leistungshalbleiters besteht, wobei die Leistungseinheit Leistungshalbleiterelemente enthält, die jeweils auf einem Lead-Frame aufgeklebt sind. Die Offenlegungsschrift EP 1 624 531 A1 beschreibt einen Einpressverbinder zum elektrisch leitfähigen Verbinden von Leiterplatten mit voneinander beabstandeten Einsteckzonen, die mit voneinander abweichenden Querschnitten und Durchmessern ausgebildet sind.

Die Offenlegungsschrift CN 106 611 758 A beschreibt eine integrierte Gehäusestruktur für ein Leistungsmodul, die ein Gehäuse, ein erstes Schaltungssubstrat, ein zweites Schaltungssubstrat, einen ersten Pin, einen zweiten Pin und einen dritten Pin umfasst, wobei das Gehäuse mit einem Hohlraum versehen ist; das zweite Schaltungssubstrat relativ oberhalb des ersten Schaltungssubstrats angeordnet ist und beide Schaltungssubstrate in dem Hohlraum untergebracht sind.

Die Offenlegungsschrift US 10,581,426 B1 beschreibt ein elektronisches Bauelement enthaltend einen ersten Halbleiterchip mit einem ersten FET, dessen Drain mit einem Schaltknoten verbunden ist, dessen Source mit einem Referenzknoten verbunden ist und dessen Gate mit einem ersten Schaltsteuerknoten verbunden ist. Der erste Chip enthält auch einen als Diode geschalteten Bipolartransistor, der eine Temperaturdiode neben dem ersten FET ausbildet. Die Temperaturdiode enthält eine Kathode, die mit dem Referenzknoten verbunden ist, und eine Anode, die mit einem Vorspannungsknoten verbunden ist.

Der Erfindung liegt die Aufgabe zugrunde, ein Halbleitermodul anzugeben, welches, im Vergleich zum Stand der Technik, kompakter ist.

Die Aufgabe wird erfindungsgemäß gelöst durch ein Halbleitermodul mit einem Gehäuse, mindestens einem Halbleiterbauelement, einem ersten Substrat und einem zweiten Substrat, wobei zumindest das Halbleiterbauelement und das erste Substrat in dem Gehäuse angeordnet sind, wobei das Halbleiterbauelement elektrisch leitend mit mindestens einem Pin verbunden ist, wobei der mindestens eine Pin mit dem zweiten Substrat kontaktiert und innerhalb des Gehäuses unlösbar verbunden ist, wobei das erste Substrat über den mindestens einen Pin kraftschlüssig im Gehäuse verbunden ist, wobei die kraftschlüssige Verbindung durch Verklemmen hergestellt ist, wobei der Pin im ersten Kontaktbereich einen Presspass-Anschluss aufweist, welcher bei der Ausbildung der kraftschlüssigen Verbindung mit dem ersten Substrat elastisch und/oder plastisch verformt ist, wobei das erste Substrat eine erste Ausnehmung aufweist, die den Pin zumindest teilweise umschließt, wobei das erste Substrat zumindest im Bereich der ersten Ausnehmung eine metallische Beschichtung aufweist, sodass das erste Substrat elektrisch leitend mit dem Halbleiterbauelement verbunden ist, wobei die metallisch beschichtete erste Ausnehmung als offene Ausnehmung ausgeführt ist, die den Pin im ersten Kontaktbereich teilweise umschließt.

Ferner wird die Aufgabe erfindungsgemäß durch einen Umrichter mit mindestens einem derartigen Halbleitermodul gelöst.

Darüber hinaus wird die Aufgabe erfindungsgemäß durch ein Verfahren zu Herstellung eines derartigen Halbleitermoduls gelöst, wobei das erste Substrat durch Verklemmen mit dem Pin verbunden wird und daraufhin das zweite Substrat mit demselben Pin verbunden wird.

Die in Bezug auf das Halbleitermodul nachstehend angeführten Vorteile und bevorzugten Ausgestaltungen lassen sich sinngemäß auf den Umrichter und das Herstellungsverfahren übertragen.

Der Erfindung liegt die Überlegung zugrunde, in einem Halbleitermodul, welches ein Gehäuse aufweist und in welchem ein erstes Substrat und ein zweites Substrat zu kontaktieren sind, Bauraum einzusparen, indem mindestens ein Pin dazu verwendet wird ein zweites Substrat elektrisch leitend zu kontaktieren und, in einer zusätzlichen Funktion, ein erstes Substrat über den mindestens einen Pin kraftschlüssig im Gehäuse zu verbinden. Unter einer kraftschlüssigen Verbindung über den mindestens einen Pin des ersten Substrats im Gehäuse ist zu verstehen, dass das erste Substrat über mindestens einen Pin mit dem Gehäuse oder mit mindestens einer weiteren Komponente, welche mit dem Gehäuse in einer, insbesondere mechanischen, Verbindung steht, kraftschlüssig verbunden ist. Der Pin stellt eine elektrisch leitende Verbindung mit dem Halbleiterbauelement her und ist innerhalb des Gehäuses unlösbar verbunden. Eine unlösbare Verbindung wird beispielsweise durch Vergießen, Löten oder Sintern hergestellt. Aufgrund der unlösbaren Verbindung des Pins im Gehäuse wird das erste Substrat über den Pin im Gehäuse kraftschlüssig verbunden. Die kraftschlüssige Verbindung wird durch Verklemmen hergestellt. Durch eine derartige Anordnung werden Verbindungsmittel, beispielsweise Schrauben und/oder weitere Pins, sowie Bauraum eingespart. Das erste und das zweite Substrat sind beispielsweise aus einem glasfaserverstärkten Epoxidharz, insbesondere FR4, hergestellt und weisen beispielsweise eine beidseitige zumindest teilweise strukturierte Metallisierung, insbesondere eine Oberflächenmetallisierung, auf. Zumindest das erste Substrat ist zusammen mit dem Halbleiterbauelement in dem Gehäuse angeordnet, was zusätzlich Bauraum einspart. Bei der Montage wird zunächst das erste Substrat über den Pin kraftschlüssig verbunden, woraufhin das zweite Substrat mit demselben Pin verbunden wird. Ein derartiges Herstellungsverfahren ist leicht und kostengünstig zu realisieren.

Das erste Substrat weist eine erste Ausnehmung auf, die den Pin zumindest teilweise umschließt. Die Ausnehmung ist als geschlossene Ausnehmung, die den Pin vollständig umschließt, oder als offene beziehungsweise geöffnete Ausnehmung, die den Pin teilweise umschließt, ausgeführt. Eine Kontur der Ausnehmung ist abgerundet oder weist zumindest eine Ecke auf. Durch eine derartige Ausnehmung wird zusätzlich zur kraftschlüssigen Verbindung ein Formschluss erreicht, was zu einer mechanisch stabileren Verbindung führt.

Ferner weist das erste Substrat zumindest im Bereich der ersten Ausnehmung eine metallische Beschichtung auf, sodass das erste Substrat elektrisch leitend mit dem Halbleiterbauelement verbunden ist. Insbesondere im Vergleich zum Löten ist bei einer derartigen Verbindung kein zusätzlicher Arbeitsschritt erforderlich.

Darüber hinaus ist die metallisch beschichtete erste Ausnehmung als offene Ausnehmung ausgeführt, die den Pin im ersten Kontaktbereich teilweise, insbesondere maximal zur Hälfte, umschließt. Eine derartige Ausnehmung ist insbesondere am Rand des ersten Substrats oder am Rand einer Aussparung des ersten Substrats angeordnet, wo beispielsweise keine zu bestückenden Komponenten, insbesondere SMD-Komponenten, angeordnet sind, sodass kein zusätzlicher Platz für die erste Ausnehmung erforderlich ist. Eine derartige offene Ausnehmung ist daher platzsparend.

Besonders vorteilhaft weist der Pin in einem ersten Kontaktbereich mit dem ersten Substrat ein Übermaß mit einem elastisch und/oder plastisch nachgebenden Bereich zur Herstellung der kraftschlüssigen Verbindung auf. Ein Übermaß ist beispielsweise eine Verdickung, insbesondere eine Stanzung. Ist der Bereich vorwiegend elastisch nachgebend ausgeführt, ist die kraftschlüssige Verbindung reversibel. Durch einen derartig ausgestalteten ersten Kontaktbereich ist das Substrat einfach im Gehäuse verbindbar.

Bei einer weiteren Ausgestaltung ist die metallisch beschichtete erste Ausnehmung als Bohrungssegment ausgeführt. Derartige Bohrungssegmente sind einfach und kostengünstig herstellbar.

Eine weitere Ausführungsform sieht vor, dass der Pin derartig in der metallisch beschichteten ersten Ausnehmung angeordnet ist, dass eine im Wesentlichen linienförmige Pressungsverteilung ausgebildet ist. Eine derartige Pressungsverteilung ist für die kraftschlüssige Verbindung, insbesondere Klemmung, des ersten Substrats ausreichend und ist einfach und kostengünstig herstellbar.

Bei einer weiteren Ausgestaltung weist das zweite Substrat eine metallisch beschichtete zweite Ausnehmung auf, über welche der Pin kraftschlüssig und/oder stoffschlüssig mit dem zweiten Substrat elektrisch leitend verbunden ist. Eine kraftschlüssige Verbindung ist beispielsweise durch Einpressen und eine stoffschlüssige Verbindung ist beispielsweise durch Löten herstellbar. Erfahrungsgemäß haben sich derartige Verbindungen als vorteilhaft erwiesen.

Eine weitere Ausführungsform sieht vor, dass ein Durchmesser der zweiten Ausnehmung kleiner als ein Durchmesser der ersten Ausnehmung ist. Beispielsweise wird bei einer Fertigung des Halbleitermoduls zuerst das erste Substrat mit der größeren ersten Ausnehmung über den zweiten Kontaktbereich des Pins bewegt, ohne diesen zu berühren und wird im Bereich des ersten Kontaktbereichs kraftschlüssig verbunden. Daraufhin wird das zweite Substrat mit der kleineren zweiten Ausnehmung im zweiten Kontaktbereich desselben Pins verbunden. Durch die unterschiedlichen Durchmesser sind zwei Substrate einfach und kostengünstig mit demselben Pin verbindbar.

Bei einer weiteren Ausgestaltung ist das zweite Substrat über den mindestens einen Pin elektrisch leitend mit dem Halbleiterbauelement verbunden ist. Auf diese Weise ist das Halbleiterbauelement platzsparend mit zwei Substraten verbindbar.

Eine weitere Ausführungsform sieht vor, dass der Pin als freistehender Pin ausgeführt ist und einen elastischen Abschnitt aufweist. Ein derartiger freistehender Pin ist außerhalb des Gehäuses, welches beispielsweise ein Keramiksubstrat umschließt, angeordnet und frei auf dem Keramiksubstrat positionierbar. Der elastische Abschnitt gleicht thermische Belastungen, insbesondere thermische Längendehnungen, aus und trägt so zur mechanischen Stabilität bei.

Bei einer weiteren Ausgestaltung ist der Pin zumindest teilweise im Gehäuse verlaufend angeordnet. Beispielsweise ist der Pin zumindest teilweise in das Gehäuse eingegossen. Erfahrungsgemäß hat sich eine derartige Anordnung als vorteilhaft erwiesen.

Eine weitere Ausführungsform sieht vor, dass das Halbleitermodul einen Sensor umfasst, welcher zumindest einen Sensoranschluss aufweist, wobei das Halbleiterbauelement zumindest einen Treiberanschluss umfasst und wobei zumindest ein Sensoranschluss und zumindest ein Treiberanschluss über einen gemeinsamen Pin elektrisch leitend miteinander verbunden sind. Der Sensor ist beispielsweise als Temperatursensor ausgeführt, welcher thermisch mit dem Halbleiterbauelementverbunden ist. Beispielsweise sind ein Treiberanschluss, insbesondere ein Emitteranschluss, und ein Sensoranschluss mit einem gemeinsamen Bezugspotential, insbesondere mit einer negativen, Versorgungsspannung des Halbleiterbauelements verbunden. Alternativ wird ein gemeinsamer Pin über ein Frequenzmultiplexverfahren verwendet, wobei der Treiberanschluss in einem ersten Frequenzbereich und der Sensoranschluss in einem zweiten Frequenzbereich betrieben werden. Ein derartiger gemeinsamer Pin spart Bauraum im Halbleitermodul ein.

Im Folgenden wird die Erfindung anhand der in den Figuren dargestellten Ausführungsbeispiele näher beschrieben und erläutert. Die Figuren 1,3,4 und 5 zeigen Ausführungsformen der beanspruchten Erfindung. Die Abbildungen 2 und 6 zeigen Beispiele, die für das Verständnis der Erfindung von Nutzen sind.

Es zeigen:

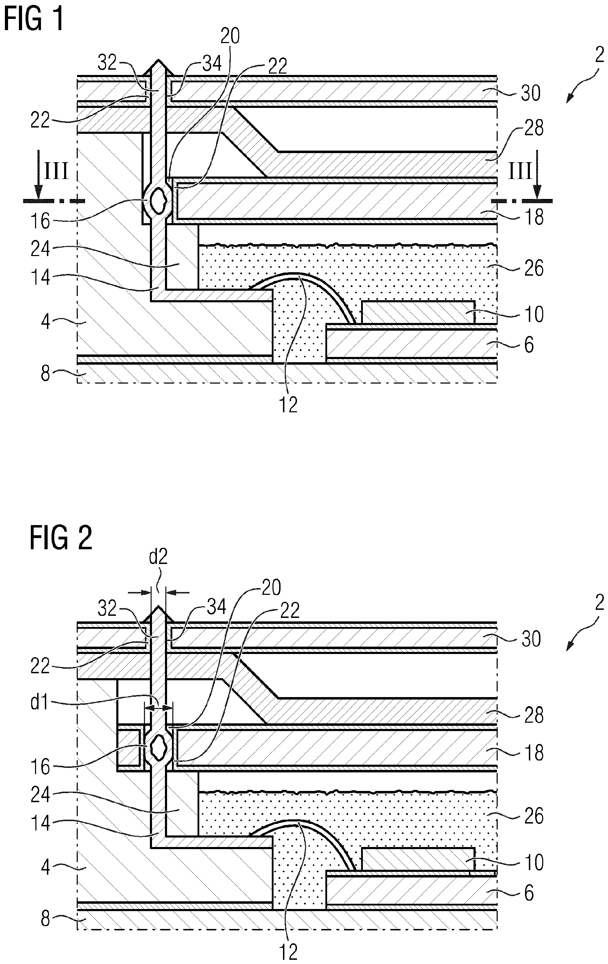

- FIG 1: eine schematische Querschnittsdarstellung eines Ausschnitts einer ersten Ausgestaltung eines Halbleitermoduls,
- FIG 2: eine schematische Querschnittsdarstellung eines Ausschnitts einer zweiten Ausgestaltung eines Halbleitermoduls, die keine Ausführungsform der Erfindung ist,

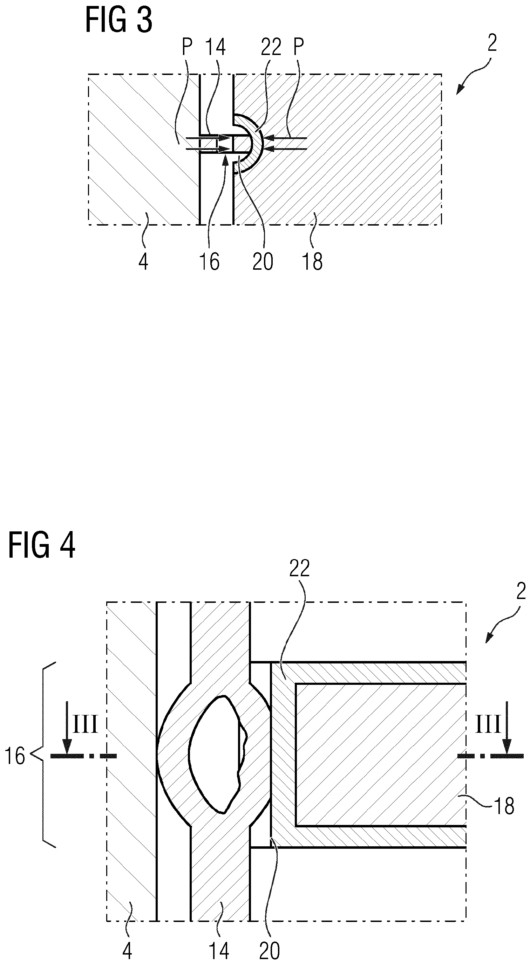

- FIG 3: eine vergrößerte Längsschnittdarstellung der ersten Ausgestaltung eines Halbleitermoduls im ersten Kontaktbereich,
- FIG 4: eine vergrößerte Querschnittsdarstellung der ersten Ausgestaltung eines Halbleitermoduls im ersten Kontaktbereich,

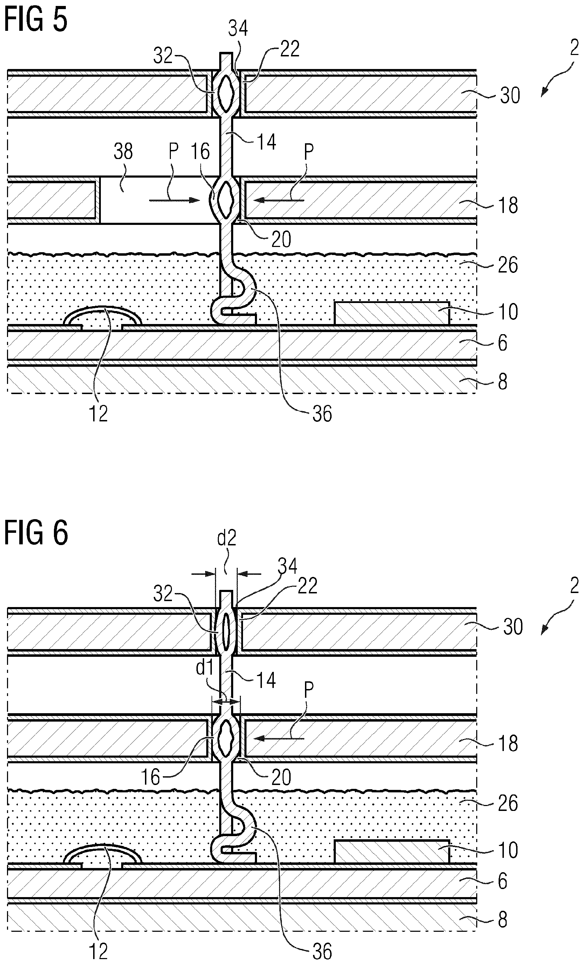

- FIG 5: eine schematische Querschnittsdarstellung eines Ausschnitts einer dritten Ausgestaltung eines Halbleitermoduls,
- FIG 6: eine schematische Querschnittsdarstellung eines Ausschnitts einer vierten Ausgestaltung eines Halbleitermoduls, die keine Ausführungsform der Erfindung ist,

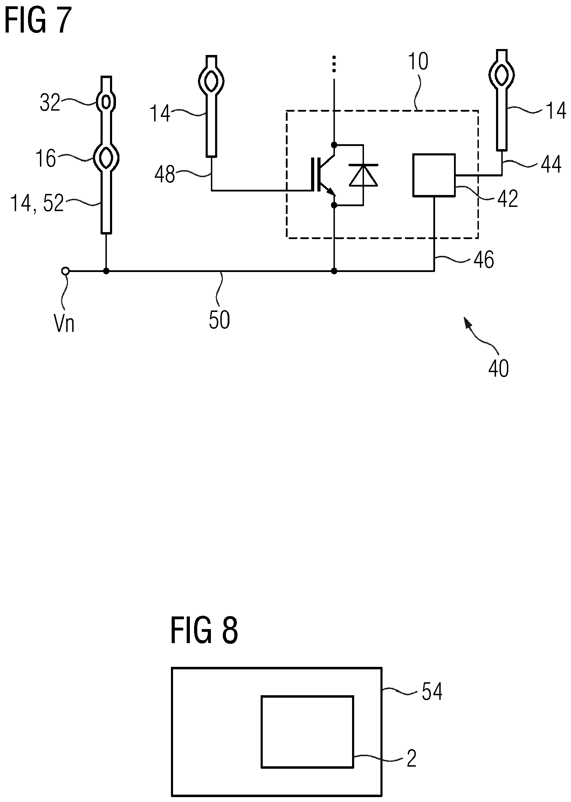

- FIG 7: eine schematische Darstellung eines Teils einer Schaltung des Halbleitermoduls und
- FIG 8: eine schematische Darstellung eines Umrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

FIG 1 zeigt eine schematische Querschnittsdarstellung eines Ausschnitts einer ersten Ausgestaltung eines Halbleitermoduls 2, welches ein Gehäuse 4 aufweist, das aus einem Kunststoff gefertigt ist. Das Gehäuse 4 weist eine offene Unterseite auf und umschließt ein DCB-Keramiksubstrat 6, welches beispielsweise Aluminiumoxid und/oder Aluminiumnitrid enthält und eine beidseitige zumindest teilweise strukturierte Metallisierung, welche beispielsweise Kupfer enthält, aufweist. Das Gehäuse 4 und das DCB-Keramiksubstrat 6 liegen auf einer metallischen Bodenplatte 8 auf und sind mit dieser, insbesondere stoffschlüssig, verbunden. Die Bodenplatte 8 ist insbesondere als Kühlkörper, welcher beispielsweise Aluminium und/oder Kupfer enthält, ausgeführt, wobei die der Bodenplatte 8 zugewandte Metallisierung des DCB-Keramiksubstrats 6 elektrisch und thermisch leitend mit der Bodenplatte 8 verbunden ist. Auf der Bodenplatte 8 abgewandten Metallisierung des DCB-Keramiksubstrats 6 ist ein Halbleiterbauelement 10 stoffschlüssig mit der Metallisierung des DCB-Keramiksubstrats 6 verbunden. Das Halbleiterbauelement 10 ist über einen Bonddraht 12 elektrisch leitend mit einem Pin 14 verbunden, welcher in das Gehäuse 4 eingebettet ist. Der Pin 14 weist in einem ersten Kontaktbereich 16 ein Übermaß mit einem elastisch und/oder plastisch nachgebenden Bereich auf, wobei der erste Kontaktbereich 16 aus dem Gehäuse 4 hervorsteht. Der Pin 14 weist im ersten Kontaktbereich 16 einen Presspass-Anschluss auf. Ein erstes Substrat 18, welches beispielsweise zumindest eine Treiberschaltung, Signalverarbeitung und/oder eine Snubber-Schaltung umfasst, ist über den Pin 14 im Gehäuse durch Einklemmen kraftschlüssig verbunden, wobei der Pin 14 im ersten Kontaktbereich 16 elastisch und/oder plastisch verformt wird. Das erste Substrat 18 weist eine erste Ausnehmung 20 auf, in welche der Pin 14 teilweise aufgenommen ist. Darüber hinaus weist das erste Substrat 18 eine beidseitige zumindest teilweise strukturierte Metallisierung, insbesondere eine Oberflächenmetallisierung, auf und ist aus einem glasfaserverstärkten Epoxidharz, insbesondere FR4, hergestellt. Im Bereich der ersten Ausnehmung 20 weist das erste Substrat 18 eine vertikale Metallisierung 22 auf, welche mit der Oberflächenmetallisierung elektrisch leitend verbunden ist, sodass das erste Substrat 18 über den Pin 14 elektrisch leitend mit dem Halbleiterbauelement 12 verbunden ist. Insbesondere umschließt die metallisch beschichtete erste Ausnehmung 20 den Pin 14 im ersten Kontaktbereich 16 maximal zur Hälfte, wobei die erste Ausnehmung 20 beispielsweise als Bohrungssegment ausgeführt ist. Alternativ ist die erste Ausnehmung 20 gefräst ausgeführt und/oder weist mindestens eine Ecke auf. Auf mindestens einer gegenüberliegenden Seite des Halbleitermoduls 2, welches aus Gründen der Übersichtlichkeit nicht dargestellt ist, ist das erste Substrat 18 über mindestens einen weiteren Pin 14 oder über das Gehäuse 4 selbst zur Herstellung der kraftschlüssigen Verbindung kontaktiert.

Darüber hinaus weist das Gehäuse 4 im Wesentlichen unmittelbar unterhalb des ersten Kontaktbereichs 16 eine Auflagefläche 24 auf, sodass das erste Substrat 18 im Wesentlichen horizontal auf dem Gehäuse 4 aufliegt. Unterhalb der Auflagefläche 24 umfasst das Halbleitermodul 2 eine Vergussmasse 26, welche das Halbleiterbauelement 10 und den Bonddraht 12 umschließt. Ein Deckel 28, welcher beispielsweise aus einem Kunststoff hergestellt ist, ist auf dem ersten Substrat 18 angeordnet, wobei das erste Substrat 18 optional durch den Deckel 28 auf das Gehäuse 4 gepresst wird. Der Pin 14 verläuft außerhalb des Gehäuses 4 durch den Deckel 28 und ein zweites Substrat 30, wobei das zweite Substrat 30 eine beidseitige zumindest teilweise strukturierte Metallisierung, insbesondere Oberflächenmetallisierung, aufweist und aus einem glasfaserverstärkten Epoxidharz, insbesondere FR4, hergestellt ist. Der Pin 14 ist in einem zweiten Kontaktbereich 32 in einer, insbesondere zylinderförmigen, zweiten Ausnehmung 34 aufgenommen, welche den Pin 14 vollständig umgibt. Im Bereich der zweiten Ausnehmung 34 weist das zweite Substrat 30 eine vertikale Metallisierung 22 auf, welche mit der Oberflächenmetallisierung elektrisch leitend verbunden ist. Insbesondere bedeckt die vertikale Metallisierung 22 die zylinderförmige erste Ausnehmung 20 vollständig. Alternativ weist die Ausnehmung 20 eine eckige oder andersartige Form auf.

Der Pin 14 ist exemplarisch stoffschlüssig über eine Lötverbindung, mit der Metallisierung des zweiten Substrats 30 elektrisch und mechanisch verbunden, sodass das zweite Substrat 30 über den Pin 14 elektrisch leitend mit dem Halbleiterbauelement 10 verbunden ist. Das zweite Substrat 30, welches beispielsweise ein Interface und/oder eine Regelung aufweist, ist über die Verbindung mit dem Pin 14 im Halbleitermodul 2 fixiert. Optional ist das zweite Substrat 30 über weitere Befestigungsmittel, beispielsweise Schrauben, welche aus Gründen der Übersichtlichkeit nicht dargestellt sind, mit dem Gehäuse 4 verbunden.

FIG 2 zeigt eine schematische Querschnittsdarstellung eines Ausschnitts einer zweiten Ausgestaltung eines Halbleitermoduls 2. Das erste Substrat 18 weist eine beidseitige zumindest teilweise strukturierte Metallisierung, insbesondere eine Oberflächenmetallisierung, sowie eine, insbesondere zylinderförmige, erste Ausnehmung 20 auf, welche den Pin 14 in einem ersten Kontaktbereich 16 vollständig umgibt. Im Bereich der ersten Ausnehmung 20 weist das erste Substrat 18 eine vertikale Metallisierung 22 auf, welche mit der Oberflächenmetallisierung elektrisch leitend verbunden ist. Insbesondere bedeckt die vertikale Metallisierung 22 die zylinderförmige erste Ausnehmung 20 vollständig. Der Pin 14 weist im ersten Kontaktbereich 16 ein Übermaß mit einem elastisch und/oder plastisch nachgebenden Bereich auf, welcher beispielhaft als Presspass-Anschluss ausgeführt ist. Durch das Einpressen des ersten Substrats 18 wird der Pin 14 im ersten Kontaktbereich 16 elastisch und/oder plastisch verformt.

Ein erster Durchmesser d1 der ersten Ausnehmung 20 ist größer als ein zweiter Durchmesser d2 der zweiten Ausnehmung 34, sodass bei einer Fertigung des Halbleitermoduls 2 zuerst das erste Substrat 18 mit der ersten Ausnehmung 20 über den zweiten Kontaktbereich 32 des Pins 14 bewegt und im Bereich des ersten Kontaktbereichs 16 kraftschlüssig verbunden wird. Daraufhin wird der Deckel 28 aufgesteckt und das zweite Substrat 30 mit dem Pin 14 verbunden. Die weitere Ausführung des Halbleitermoduls 2 in FIG 2 entspricht der Ausführung in FIG 1.

FIG 3 zeigt eine vergrößerte Längsschnittdarstellung der ersten Ausgestaltung eines Halbleitermoduls 2 im ersten Kontaktbereich 16. Der Pin 14 ist derartig in der metallisch beschichteten ersten Ausnehmung 20 angeordnet und kraftschlüssig mit dem ersten Substrat 18 verbunden, dass eine im Wesentlichen linienförmige Pressungsverteilung P ausgebildet ist. Optional berührt der Pin 14 das Gehäuse 4 zur Ausbildung der kraftschlüssigen Verbindung. Die weitere Ausführung des Halbleitermoduls 2 in FIG 3 entspricht der Ausführung in FIG 1.

FIG 4 zeigt eine vergrößerte Querschnittsdarstellung der ersten Ausgestaltung eines Halbleitermoduls 2 im ersten Kontaktbereich 16, wobei der Pin 14 einen Presspass-Anschluss aufweist, welcher bei der Ausbildung der kraftschlüssigen Verbindung mit dem ersten Substrat 18 elastisch und/oder plastisch verformt wird. Die weitere Ausführung des Halbleitermoduls 2 in FIG 4 entspricht der Ausführung in FIG 1.

FIG 5 zeigt eine schematische Querschnittsdarstellung eines Ausschnitts einer dritten Ausgestaltung eines Halbleitermoduls 2, wobei der Pin 14 als freistehender Einpresskontakt mit einem ersten Kontaktbereich 16 und einem zweiten Kontaktbereich 32 ausgeführt ist und wobei der Pin 14 im zweiten Kontaktbereich 32 einen Presspass-Anschluss aufweist, welcher mit der zweiten Ausnehmung 34 des zweiten Substrats 30 kraftschlüssig verbunden ist. Der freistehende Pin 14 ist außerhalb des Gehäuses 4, welches das DCB-Keramiksubstrat 6 umschließt, angeordnet und frei auf dem DCB-Keramiksubstrat 6 positionierbar. Darüber hinaus weist der Pin 14 einen elastischen Abschnitt 36 auf und ist mit der der Bodenplatte 8 abgewandten Metallisierung des DCB-Keramiksubstrats 6 stoffschlüssig, insbesondere durch Löten oder Sintern, verbunden.

Das erste Substrat 18 weist eine, insbesondere rechteckförmige Aussparung 38 mit einer zumindest teilweise umlaufenden vertikalen Metallisierung 22 auf. Der Pin 14 weist im ersten Kontaktbereich 16 ein Übermaß mit einem elastisch und/oder plastisch nachgebenden Bereich auf, der exemplarisch als Presspass-Anschluss ausgeführt ist. Das erste Substrat 18 weist in der Aussparung 38 zumindest eine erste Ausnehmung 20 auf, in welcher die vertikale Metallisierung 22 ausgebildet und mit der Oberflächenmetallisierung elektrisch leitend verbunden ist. Über die Aussparung 38 ist beispielsweise das zweite Substrat 30 unmittelbar mit dem DCB-Keramiksubstrat 6 verbindbar. Der Pin 14 ist in der ersten Ausnehmung 20 teilweise aufgenommen und mit dieser kraftschlüssig verbunden, sodass das erste Substrat 18 über den Pin 14 elektrisch leitend mit dem Halbleiterbauelement 12 verbunden ist. Insbesondere umschließt die metallisch beschichtete erste Ausnehmung 20 den Pin 14 im ersten Kontaktbereich 16 maximal zur Hälfte, wobei die erste Ausnehmung 20 exemplarisch als Bohrungssegment ausgeführt ist. Alternativ ist die erste Ausnehmung 20 gefräst mit mindestens einer Ecke ausgeführt. Der Pin 14 ist derartig in der metallisch beschichteten ersten Ausnehmung 20 angeordnet und kraftschlüssig mit dem ersten Substrat 18 verbunden, dass eine im Wesentlichen linienförmige Pressungsverteilung P ausgebildet ist. Die weitere Ausführung des Halbleitermoduls 2 in FIG 5 entspricht der Ausführung in FIG 1.

FIG 6 zeigt eine schematische Querschnittsdarstellung eines Ausschnitts einer vierten Ausgestaltung eines Halbleitermoduls 2. Das erste Substrat 18 weist eine beidseitige zumindest teilweise strukturierte Metallisierung, insbesondere eine Oberflächenmetallisierung, sowie eine, insbesondere zylinderförmige, erste Ausnehmung 20 auf, welche den Pin 14 in einem ersten Kontaktbereich 16 vollständig umgibt. Der Pin 14 ist mit dem ersten Substrat 18 kraftschlüssig verbunden, wodurch der Pin 14 im ersten Kontaktbereich 16 elastisch und/oder plastisch verformt wird. Ein erster Durchmesser d1 der ersten Ausnehmung 20 ist größer als ein zweiter Durchmesser d2 der zweiten Ausnehmung 34, sodass bei einer Fertigung des Halbleitermoduls 2 zuerst das erste Substrat 18 mit der größeren ersten Ausnehmung 20 über den zweiten Kontaktbereich 32 des Pins 14 bewegt und im Bereich des ersten Kontaktbereichs 16 kraftschlüssig verbunden wird. Daraufhin wird das zweite Substrat 30 mit der kleineren zweiten Ausnehmung 34 im zweiten Kontaktbereich 32 desselben Pins 14 verbunden. Die weitere Ausführung des Halbleitermoduls 2 in FIG 6 entspricht der Ausführung in FIG 5.

FIG 7 zeigt eine schematische Darstellung eines Teils einer Schaltung 40 des Halbleitermoduls 2, welche ein Halbleiterbauelement 10, das als IGBT ausgeführt ist, mit einem Sensor 42 aufweist. Alternativ ist der Sensor 42 außerhalb des Halbleiterbauelements 10 angeordnet und mit dem Halbleiterbauelement 10 verbunden. Beispielsweise ist der Sensor 42 als Temperatursensor ausgeführt, welcher thermisch mit dem Halbleiterbauelement 10 verbunden ist. Der Sensor weist einen ersten Sensoranschluss 44 und einen zweiten Sensoranschluss 46 auf. Das Halbleiterbauelement 10 weist einen ersten Treiberanschluss 48 und einen zweiten Treiberanschluss 50 auf, wobei der zweite Sensoranschluss 46 und der zweite Treiberanschluss 50 kurzgeschlossen und mit einer, insbesondere negativen, Versorgungsspannung Vn des Halbleiterbauelements 10 verbunden sind. Dem ersten Sensoranschluss 44 und dem ersten Treiberanschluss 48 ist jeweils ein Pin 14 zugewiesen, wobei beispielsweise der Pin 14 des ersten Treiberanschlusses 48 kürzer als der Pin 14 des ersten Sensoranschlusses 44 ausgestaltet ist, sodass der erste Treiberanschluss 48 mit dem ersten Substrat 18 und der erste Sensoranschluss 44 mit dem zweiten Substrat 30 verbindbar sind. Die kurzgeschlossenen Anschlüsse 46, 50 sind mit einem gemeinsamen Pin 52, welcher einen erster Kontaktbereich 16 zur Verbindung mit dem ersten Substrat 18 oder einen zweiten Kontaktbereich 32 zur Verbindung mit dem zweiten Substrat 30 aufweist, verbunden. Die Pins 14, 52 sind in FIG 7 symbolisch abstrahiert dargestellt, wobei der gemeinsame Pin 52, wie in den Figuren 1 bis 4 dargestellt, als ein in das Gehäuse 4 zumindest teilweise integrierter Pin 14 oder, wie in den Figuren 5 bis 6 dargestellt, als freistehender Pin 14 ausführbar ist. FIG 8 zeigt eine schematische Darstellung eines Umrichters 54 mit einem Halbleitermodul 2. Je nach Architektur weist der Umrichter 54 zumindest ein weiteres Halbleitermodul 2 auf.

## Patentansprüche

1. Halbleitermodul (2) mit einem Gehäuse (4), mindestens einem Halbleiterbauelement (10), einem ersten Substrat (18) und einem zweiten Substrat (30),
wobei zumindest das Halbleiterbauelement (10) und das erste Substrat (18) in dem Gehäuse (4) angeordnet sind,
wobei das Halbleiterbauelement (10) elektrisch leitend mit mindestens einem Pin (14) verbunden ist,
wobei der mindestens eine Pin (14) mit dem zweiten Substrat (30) kontaktiert und innerhalb des Gehäuses (4) unlösbar verbunden ist,
wobei das erste Substrat (18) über den mindestens einen Pin (14) kraftschlüssig im Gehäuse (4) verbunden ist,
wobei die kraftschlüssige Verbindung durch Verklemmen hergestellt ist,
wobei der Pin (14) in einem ersten Kontaktbereich (16) einen Presspass-Anschluss aufweist, welcher bei der Ausbildung der kraftschlüssigen Verbindung mit dem ersten Substrat (18) elastisch und/oder plastisch verformt ist,
wobei das erste Substrat (18) eine erste Ausnehmung (20) aufweist, die den Pin (14) zumindest teilweise umschließt, wobei das erste Substrat (18) zumindest im Bereich der ersten Ausnehmung (20) eine metallische Beschichtung (22) aufweist, sodass das erste Substrat (18) elektrisch leitend mit dem Halbleiterbauelement (10) verbunden ist,
wobei die metallisch beschichtete erste Ausnehmung (20) als offene Ausnehmung ausgeführt ist, die den Pin (14) im ersten Kontaktbereich (16) teilweise umschließt.

2. Halbleitermodul (2) nach Anspruch 1,
wobei der Pin (14) in einem ersten Kontaktbereich (16) mit dem ersten Substrat (18) ein Übermaß mit einem elastisch und/oder plastisch nachgebenden Bereich zur Herstellung der kraftschlüssigen Verbindung aufweist.

3. Halbleitermodul (2) nach einem der Ansprüche 1 oder 2, wobei die metallisch beschichtete erste Ausnehmung (20) als offene Ausnehmung ausgeführt ist, die den Pin (14) im ersten Kontaktbereich (16) maximal zur Hälfte umschließt.

4. Halbleitermodul (2) nach einem der vorherigen Ansprüche, wobei der Pin (14) derartig in der metallisch beschichteten ersten Ausnehmung (20) angeordnet ist, dass eine im Wesentlichen linienförmige Pressungsverteilung (P) ausgebildet ist.

5. Halbleitermodul (2) nach einem der vorherigen Ansprüche, wobei die metallisch beschichtete erste Ausnehmung (20) als Bohrungssegment ausgeführt ist.

6. Halbleitermodul (2) nach einem der vorherigen Ansprüche, wobei das zweite Substrat (30) eine metallisch beschichtete zweite Ausnehmung (34) aufweist, über welche der Pin (14) kraftschlüssig und/oder stoffschlüssig mit dem zweiten Substrat (30) elektrisch leitend verbunden ist.

7. Halbleitermodul (2) nach Anspruch 6,
wobei ein Durchmesser (d2) der zweiten Ausnehmung (34) kleiner als ein Durchmesser (d1) der ersten Ausnehmung (20) ist.

8. Halbleitermodul (2) nach einem der Ansprüche 6 oder 7, wobei das zweite Substrat (30) über den mindestens einen Pin (14) elektrisch leitend mit dem Halbleiterbauelement (10) verbunden ist.

9. Halbleitermodul (2) nach einem der vorherigen Ansprüche, wobei der Pin (14) als freistehender Pin ausgeführt ist und einen elastischen Abschnitt (36) aufweist.

10. Halbleitermodul (2) nach einem der Ansprüche 1 bis 8, wobei der Pin (14) zumindest teilweise im Gehäuse (4) verlaufend angeordnet ist.

11. Halbleitermodul (2) nach einem der vorherigen Ansprüche, welches einen Sensor (42) umfasst, welcher zumindest einen Sensoranschluss (44, 46) aufweist,
wobei das Halbleiterbauelement (41) zumindest einen Treiberanschluss (48, 50) umfasst und
wobei zumindest ein Sensoranschluss (44, 46) und zumindest ein Treiberanschluss (48, 50) über einen gemeinsamen Pin (52) elektrisch leitend miteinander verbunden sind.

12. Umrichter (54) mit mindestens einem Halbleitermodul (2) nach einem der vorherigen Ansprüche.

13. Verfahren zu Herstellung eines Halbleitermoduls (2) nach einem der Ansprüche 1 bis 11,
wobei das erste Substrat (18) durch Verklemmen mit dem Pin (14) verbunden wird und daraufhin das zweite Substrat (30) mit demselben Pin (14) verbunden wird.

## Claims

1. Semiconductor module (2) having a housing (4), at least one semiconductor component (10), a first substrate (18) and a second substrate (30),
wherein at least the semiconductor component (10) and the first substrate (18) are arranged in the housing (4), wherein the semiconductor component (10) is electrically conductively connected to at least one pin (14),
wherein the at least one pin (14) is in contact with the second substrate (18) and is connected within the housing (4) in a non-releasable manner,
wherein the first substrate (18) is connected via the at least one pin (14) in a non-positive locking manner in the housing (4),
wherein the non-positive locking connection is produced by clamping,
wherein the pin (14) in a first contact region (16) has a press-fit connection which, when the non-positive locking connection is formed, is deformed elastically and/or plastically with the first substrate (18),
wherein the first substrate (18) has a first recess (20) which at least in part encompasses the pin (14),
wherein at least in the region of the first recess (20) the first substrate (18) has a metal coating (22) with the result that the first substrate (18) is electrically conductively connected to the semiconductor component (10),
wherein the metal coated first recess (20) is designed as an open recess, which encompasses the pin (14) in part in the first contact region (16).

2. Semiconductor module (2) according to claim 1,
wherein in a first contact region (16) with the first substrate (18) the pin (14) is oversized with an elastically and/or plastically yielding region so as to produce the non-positive locking connection.

3. Semiconductor module (2) according to one of claims 1 or 2, wherein the metal-coated first recess (20) is configured as an open recess that encompasses the pin (14) by a maximum of half in the first contact region (16).

4. Semiconductor module (2) according to one of the preceding claims,
wherein the pin (14) is arranged in the metal-coated first recess (20) in such a manner that an essentially linear pressure distribution (P) is provided.

5. Semiconductor module (2) according to one of the preceding claims,
wherein the metal-coated first recess (20) is configured as a bore segment.

6. Semiconductor module (2) according to one of the preceding claims,
wherein the second substrate (30) has a metal-coated second recess (34) via which the pin (14) is electrically conductively connected in a non-positive locking and/or material-bonded manner to the second substrate (30).

7. Semiconductor module (2) according to claim 6,
wherein a diameter (d2) of the second recess (34) is smaller than a diameter (d1) of the first recess (20).

8. Semiconductor module (2) according to one of claims 6 or 7,
wherein the second substrate (30) is electrically conductively connected to the semiconductor component (10) via the at least one pin (14).

9. Semiconductor module (2) according to one of the preceding claims,
wherein the pin (14) is configured as a free-standing pin and has an elastic section (36).

10. Semiconductor module (2) according to one of claims 1 to 8,
wherein the pin (14) is arranged extending at least in part in the housing (4).

11. Semiconductor module (2) according to one of the preceding claims, which comprises a sensor (42) which has at least one sensor connection (44, 46),
wherein the semiconductor component (41) comprises at least one driver connection (48, 50) and
wherein at least one sensor connection (44, 46) and at least one driver connection (48, 50) are electrically conductively connected to one another via a common pin (52) .

12. Converter (54) having at least one semiconductor module (2) according to one of the preceding claims.

13. Method for producing a semiconductor module (2) according to one of claims 1 to 11,
wherein the first substrate (18) is connected to the pin (14) by clamping and subsequently the second substrate (30) is connected to the same pin (14).

## Revendications

1. Module (2) à semiconducteur comprenant un boîtier (4), au moins un composant (10) à semiconducteur, un premier substrat (18) et un deuxième substrat (30),
dans lequel au moins le composant (10) à semiconducteur et le premier substrat (18) sont disposés dans le boîtier (4),
dans lequel le composant (10) à semiconducteur est relié d'une manière conductrice de l'électricité à au moins une broche (14), dans lequel la au moins une broche (14) est en contact avec le deuxième substrat (30) et y est liée de manière indétachable à l'intérieur du boîtier (4),
dans lequel le premier substrat (18) est relié dans le boîter (4) à coopération de force par la au moins une broche (14),
dans lequel la liaison à coopération de force est produite par coincement,
dans lequel la broche (14) a, dans une première partie (16) de contact, une borne s'adaptant par pression, qui se déforme élastiquement et/ou plastiquement lors de constitution de la liaison à coopération de force avec le premier substrat (18), dans lequel le premier substrat (18) a un premier évidement (20), qui entoure au moins en partie la broche (14),
dans lequel le premier substrat (18) a un revêtement (22) métallique au moins dans la partie du premier évidement (20), de manière à relier le premier substrat (18) d'une manière conductrice de l'électricité au composant (10) à semiconducteur,
dans lequel le premier évidement (20) revêtu métalliquement est réalisé en évidement ouvert, qui entoure en partie la broche (14) dans la première partie (16) de contact.

2. Module (2) à semiconducteur suivant la revendication 1, dans lequel la broche (14) a, dans une première partie (16) de contact avec le premier substrat (18), un dépassement ayant une partie cédant élastiquement et/ou plastiquement pour la production de la liaison à coopération de force.

3. Module (2) à semiconducteur suivant la revendication 1 ou 2,
dans lequel le premier évidement (20) revêtu métalliquement est réalisé en évidement ouvert, qui entoure, au maximum pour la moitié, la broche (14) dans la première partie (16) de contact.

4. Module (2) à semiconducteur suivant l'une des revendications précédentes,
dans lequel la broche (14) est disposée dans le premier évidement (20) revêtu métalliquement, de manière à constituer une répartition (P) d'application d'une pression sensiblement linéaire.

5. Module (2) à semiconducteur suivant l'une des revendications précédentes,
dans lequel le premier évidement (20) revêtu métalliquement est réalisé en segment d'alésage.

6. Module (2) à semiconducteur suivant l'une des revendications précédentes,
dans lequel le deuxième substrat (30) a un deuxième évidement (34) revêtu métalliquement, par lequel la broche (14) est reliée, d'une manière conductrice de l'électricité à coopération de force et/ou à coopération de matière, au deuxième substrat (30).

7. Module (2) à semiconducteur suivant la revendication 6, dans lequel un diamètre (d2) du deuxième évidement (34) est plus petit qu'un diamètre (d1) du premier évidement (20).

8. Module (2) à semiconducteur suivant l'une des revendications 6 ou 7,
dans lequel le deuxième substrat (30) est relié d'une manière conductrice de l'électricité au composant (10) à semiconducteur par la au moins une broche (14).

9. Module (2) à semiconducteur suivant l'une des revendications précédentes,
dans lequel la broche (14) est réalisée en broche autoporteuse et a un tronçon (36) élastique.

10. Module (2) à semiconducteur suivant l'une des revendications 1 à 8,
dans lequel la broche (14) est disposée en s'étendant au moins en partie dans le boîtier (4).

11. Module (2) à semiconducteur suivant l'une des revendications précédentes,
qui comprend un capteur (42), lequel a au moins une borne (44, 46) de capteur,
dans lequel le composant (41) à semiconducteur comprend au moins une borne (48, 50) de circuit d'attaque, et
dans lequel au moins une borne (44, 46) du capteur et au moins une borne (48, 50) de circuit d'attaque sont reliées entre elle d'une manière conductrice de l'électricité par une broche (52) commune.

12. Convertisseur (54) ayant au moins un module (2) à semiconducteur suivant l'une des revendications précédentes.

13. Procédé de production d'un module (2) à semiconducteur suivant l'une des revendications 1 à 11,
dans lequel on relie le premier substrat (18) à la broche (14) par coincement et ensuite on relie le deuxième substrat (30) à la même broche (14).
